**Europäisches Patentamt**

**European Patent Office**

**Office européen des brevets**

(11) Veröffentlichungsnummer: **0 103 078**
A2

# (12) EUROPÄISCHE PATENTANMELDUNG

(21) Anmeldenummer: 83105787.2

(22) Anmeldetag: 13.06.83

(51) Int. Cl.³: **G 08 B 13/26**

(30) Priorität: 16.06.82 DE 3222640

(43) Veröffentlichungstag der Anmeldung: 21.03.84
Patentblatt 84/12

(84) Benannte Vertragsstaaten: **AT BE CH DE FR GB IT LI NL**

(71) Anmelder: **SIEMENS AKTIENGESELLSCHAFT, Berlin und München Wittelsbacherplatz 2, D-8000 München 2 (DE)**

(72) Erfinder: **Metzner, Uwe, Theodolindenstrasse 49, D-8000 München 90 (DE)**

(54) **Messanordnung für kapazitive Schutzzäune.**

(57) Zumindest an einigen Elektroden (E1 bis Ei) ist jeweils ein Sender (SEN1 bis SENi) mit jeweils unterschiedlicher Frequenz (F1 bis Fi) angeschlossen. Jeder Elektrode (E1 bis En) ist ein Übertrager (Ü1 bis Ün) zugeordnet, dessen Primärwicklung zwischen dem Sender (SEN) und Erde liegt. Jedem Übertrager (Ü1 bis Ün) sind sekundärseitig jeweils Bandfilter (BF1 bis BFi) mit einstellbaren Mittenfrequenzen (FO1 bis FOi), die den Senderfrequenzen (F1 bis Fi) entsprechen, nachgeordnet. Mit einer nachgeschalteten Meßeinrichtung (ME) werden die jeweilige Spannung (U11 bis Uni) gemessen und einem nachgeordneten Mikrocomputer (MC) zugeführt. Aus den Meßspannungen (U11 bis Uni), die den Kapazitäten (CE und CT) proportional sind, werden die Teilkapazitäten (CT) und die Eigenteilkapazitäten (CE) des Elektrodensystems ermittelt.

SIEMENS AKTIENGESELLSCHAFT   Unser Zeichen
Berlin und München   VPA 82 P 1 4 6 0 E

## Meßanordnung für kapazitive Schutzzäune

Die Erfindung betrifft eine Meßanordnung für kapazitive Schutzzäune nach dem Oberbegriff des Anspruchs 1.

Für einen sicheren Objektschutz wird häufig zusätzlich zum Gebäudeschutz die Umgebung beispielsweise mit einem Schutzzaun abgesichert. Damit soll ein unbefugtes Eindringen verhindert, zumindest aber erschwert werden. Um ein unbefugtes Eindringen zu erkennen, werden kapazitive Schutzzäune, die bei einem Annähern oder bei einem Durchdringen seitens eines Eindringlings einen Alarm auslösen, errichtet. Besonders überwachungsbedürftige und gefährdete Objekte, z.B. Kernkraftwerke oder militärische Anlagen, bedürfen einer äußerst sicheren Raumschutzanlage.

Solche Raumschutzanlagen, insbesondere Freilandanlagen, sind gewissen störenden Einflüssen ausgesetzt, so daß die Störanfälligkeit verhältnismäßig groß ist und häufig Fehlalarme ausgelöst werden. Raumschutzanlagen müssen daher so aufgebaut sein, daß die anzuzeigenden Effekte sicher, Störungen jedoch nicht zum Alarm führen.

Üblicherweise werden die Teilkapazitäten zwischen Sende- und Empfangselektroden gemessen und über eine Differentialbrücke die resultierende Differenz dieser Teilkapazität ausgewertet (z.B.DE-PS 1 220 289). Dadurch können symmetrisch auftretende Umwelteinflüsse eliminiert werden. Aus dieser resultierenden Kapazitätsdifferenz wird ein Alarm abgeleitet. Dabei

En 1 Wt/ 17.5.82

wird entweder durch eine sprunghafte Kapazitätsänderung einer bestimmten Größe oder durch eine stetige Kapazitätsänderung mit definierter Änderungsgeschwindigkeit ein Alarm ausgelöst. Diese relativ einfachen Alarmkriterien bedingen aber auch eine geringe Störsicherheit. Um einen Eindringling sicher erkennen zu können, kann man bei einer derartigen Anlage die Ansprechempfindlichkeit erhöhen. Dies bringt aber im allgemeinen mit sich, daß die Störempfindlichkeit auch größer wird, d.h. die Störsicherheit erniedrigt sich.

Es wurde auch schon vorgeschlagen, jeweils die einzelnen Teilkapazitäten zwischen den Elektroden und/oder die einzelnen Eigenteilkapazitäten zwischen einer Elektrode und Erde zu messen, die Zeitverläufe der einzelnen Kapazitätsänderungen zu speichern und auszuwerten und daraus ein Alarmkriterium abzuleiten (Eigene Anmeldung P 31 10 352.9). Ein derartiges Verfahren hat aber den Nachteil, daß in der Nähe der Elektroden eine Vielzahl aufwendiger Umschalteinrichtungen vorzusehen sind, und daß dabei relativ hohe Potentiale, z.B. 100 V, ständig an die einzelnen Elektroden an- und abgeschaltet werden müssen. Außerdem kann jeweils nur immer eine Teil- bzw. Eigenteilkapazität gemessen werden. Das bedeutet eine längere Zeit, bis sämtliche Kapazitäten gemessen sind und zur Auswertung vorliegen. Da das ständige Umschalten gewisse Einschwingzeiten bedingt, verlängert sich diese Zeit nochmals.

Aufgabe der Erfindung ist es, eine Meßanordnung zur Bestimmung der einzelnen Teilkapazitäten und/oder Eigenteilkapazitäten an einem kapazitiven Schutzzaun anzugeben, mit der sämtliche Teilkapazitäten eines Elektrodensystems gemessen und über eine Summenmessung die jeweiligen Eigenteilkapazitäten ermittelt werden können. Dabei sollen alle Teilkapazitäten gleichzeitig gemessen werden können. Aus den Meßwerten der
Teilkapazitäten soll die Eigenteilkapazität der
jeweiligen Elektrode ermittelbar sein.

Diese Aufgabe wird durch die kennzeichnenden Merkmale
des Anspruchs 1 gelöst.

Die erfindungsgemäße Meßanordnung weist beispielsweise
zu jeder Elektrode einen Sender und dazu einen Übertrager auf. Jeder Sender hat eine andere Frequenz. Auf der
Sekundärseite der Übertrager sind zu jedem Übertrager
soviele Bandfilter wie Sender vorhanden, deren Mittenfrequenzen den Senderfrequenzen entsprechen. Bei n
Elektroden und n Sendern sind also n mal n Bandfilter
erforderlich. Den Bandfiltern ist eine Meßeinrichtung
nachgeodnet, die die am Ausgang des jeweiligen Bandfilters anstehende Spannung mißt. Diese Spannungen sind
den Teilkapazitäten bzw. der Summe aus den Teil- und
Eigenteilkapaziäten des Elektrodensystems proportional.
Mit dieser Anordnung entfallen die Umschalteeinrichtungen an den Elektroden, die notwendig sind, wenn man
einen Sender jeweils einmal an alle Elektroden und die
übrigen Elektroden als Empfangselektroden schaltet. Da
mit der erfindungsgemäßen Meßanordnung alle Kapazitäten
gleichzeitig gemessen bzw. ermittelt werden, rechfertigt
sich der hohe Aufwand an Filtern. Diese müssen auch
nicht in unmittelbarer Nähe der Elektroden angeordnet
sein. Sie werden zweckmäßigerweise bei der Auswerteeinrichtung angeordnet. Dabei ist es vorteilhaft, die
Meßanordnung als Teil eines Mikrocomputers auszubilden,
in dem die den Spannungen proportionalen Teil- bzw.
Eigenteil- und Teilkapazitäten zur weiteren Bearbeitung
abspeicherbar sind.

Da in vielen Fällen zur Erkennung eines Eindringlings
nicht sämtliche Teil- und Eigenteilkapazitäten gemessen

0103078

und bewertet werden müssen, können wenige Sender als Elektroden vorgesehen werden. Dadurch verringert sich auch die Zahl der Filter.

In einer zweckmäßigen Weiterbildung der Erfindung arbeitet die Meßanordnung im Multiplexbetrieb. Dazu ist zwischen den Übertragern und den Bandfiltern ein erstes Schaltnetzwerk vorgesehen. Die Anzahl der Bandfilter reduziert sich dabei um den Faktor n. Es sind also nur mehr soviele Bandfilter erforderlich, wie Sender angeschlossen sind. Mit dem Schaltnetzwerk sind beispielsweise bei vier Elektroden mit vier zugeordneten Sendern die vier Übertrager mit den vier Bandfiltern verbindbar. Bei vier Bandfiltern sind vier Schaltschritte erforderlich, um jeden Übertrager einmal mit jedem Filter zu verbinden. Dabei werden die jeweiligen Spannungen gemessen und die entsprechenden Kapazitätswerte im Mikrocomputer ermittelt. In gleicher Weise kann ein weiteres Schaltnetzwerk zwischen dem Bandfilter und den dem Computer vorgeschalteten Analog/Digital-Wandlern vorgesehen sein, um die Zahl der A/D-Wandler der Filter auf n zu verringern.

Zweckmäßigerweise wird man zur Erzeugung der verschiedenen Sendefrequenzen einen quarzgesteuerten Muttergenerator vorsehen, der über einen Teiler, z.B. SAB 8253, vom Rechner her gesteuert wird. Ebenso wird man die i Bandfilter über eine phasenempfindliche Gleichrichtungseinrchtung realisieren.

Anhand der Zeichnung wird die erfindungsgemäße Meßanordnung näher erläutert.

Dabei zeigen

Fig. 1   eine prinzipielle Meßanordnung mit n Elekroden und i = n Sendern,

Fig. 2 eine prinzipielle Meßanordnung mit drei Elektroden und drei Sendern,

Fig. 3 ein Blockschaltbild für eine erfindungsgemäße Meßanordnung für Multiplexbetrieb und

Fig. 4 eine prinzipielle Meßanordnung mit weniger Sendern als Elektroden (i n).

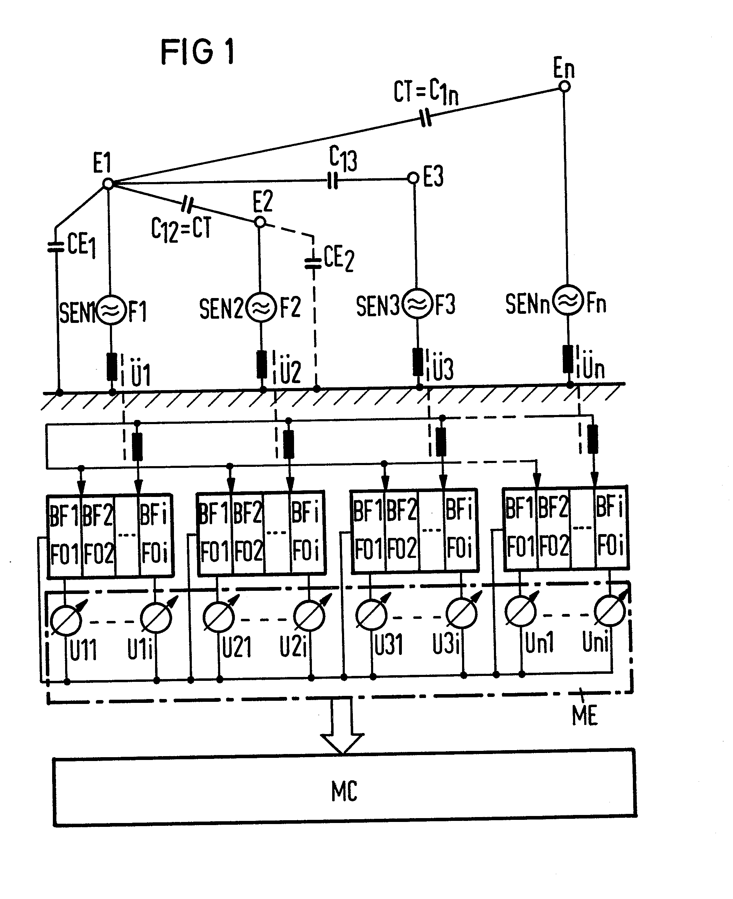

In Fig.1 sind prinzipielle dargestellt die Elektroden E1 bis En. Jede Elektrode ist mit einem Sender SEN1 bis SENi verbunden, so daß i = n. Jeder Sender erzeugt eine Frequenz, die sich von der Frequenz der andern Sender unterscheidet (F1 bis Fi). Zwischen dem Sender und der Erde ist jeweils ein Übertrager Ü1 bis Ün angeordnet. An der Sekundärseite der Übertrager Ü1 bis Ün sind jeweils Bandfilter BF1 bis BFi parallel geschaltet. Die Mittenfrequenzen FO1 bis FOi entsprechen den jeweiligen Senderfrequenzen F1 bis Fi. Mit einer Meßeinrichtung ME wird an jedem Bandfilter (BF11 bis BFni) die jeweilige Meßspannung (U11 bis Uni) ermittelt. Diese Spannungen sind den Kapazitäten des Elektrodensystems proportional. In dem der Meßeinrichtung ME nachgeordnetem Mikrocomputer MC werden die Kapazitäten ermittelt.

Bei einer derartigen Meßanordnung sind alle Elektroden Sendeelektroden. Bei der Spannungsmessung nach den Bandfiltern wirkt aber nur die Elektrode, z.B. E1, als Sendeelektrode, der ein Bandfilter zugeordnet ist, dessen Mittenfrequenz gleich der Sendefrequenz des zu dieser zugehörigen Elektrode ist. In diesem Fall ist der Sender SEN1 an der Elektrode E1 angeschlossen, so daß am Bandfilter BF11 die Spannung U11 in einem bestimmten Verhältnis zum Strom I, der zur Elektrode E1 fließt, steht. Die Meßspannung U11 ist proportional zu den Kapazitäten $C_{E1} + \sum_{r=2}^{n} C_{1i}$, die Spannung U12 ist proportional $C_{21}$ und die Spannung U1i ist proportional $C_{n1}$.

0103078

Bei hinreichend niedrigen Innenwiderständen der Sender SEN und hinreichend niedrigen Impedenzen der Überrager Ü1 bis Ün wirken die Elektroden wie geerdet und somit wie Empfangselektroden. Mit dieser Meßanordnung ist jede Elektrode einmal Sendeelektrode und die übrigen Elektroden sind Empfangselektroden, ohne daß dabei die Elektroden immer umgeschaltet werden müssen. Außerdem können auf diese Weise sämtliche Teil- und Eigenteilkapazitäten aus den gleichzeitig gemessenen Spannungen ermittelt werden.

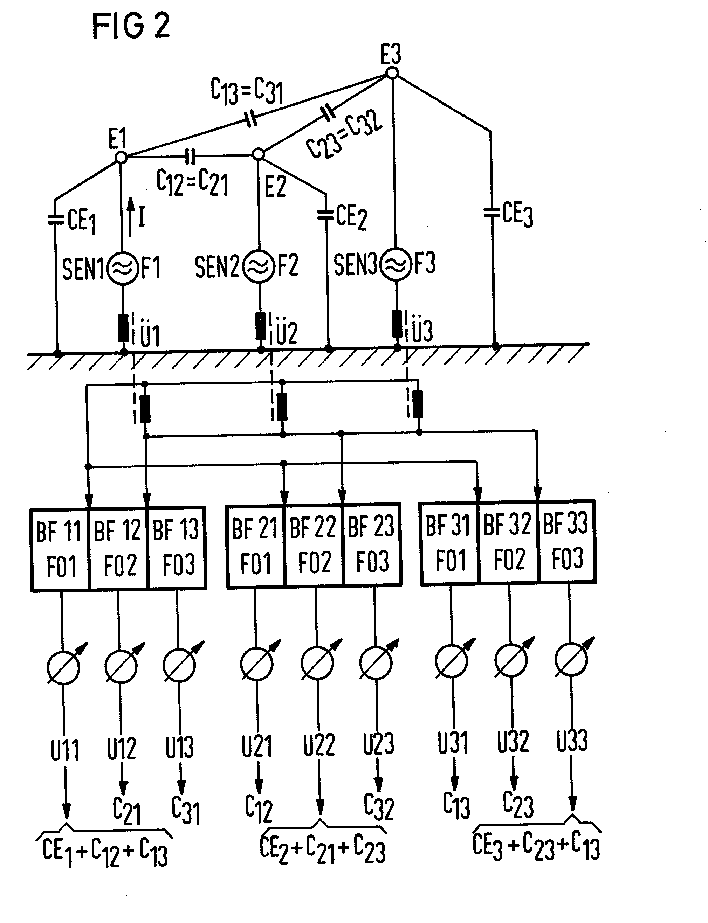

Der Einfachheit halber seien die Meßspannungen und die proportionalen Kapazitäten am Beispiel dreier Elektroden n = 3 mit drei (i = 3) Sendern in Fig.2 behandelt. Es sind jedem Überrager Ü1 bis Ü3 jeweils drei Bandfilter BF1 bis BF3 zugeordnet, also insgesamt neun Bandfilter BF11 bis BF33 angeordnet. Entsprechend werden neun Spannungen U11 bis U33 gemessen.

Dabei ist die am Bandfilter BF11 mit der Mittenfrequenz FO1 gemessene Spannung U11 der Summe aus Eigenteil- kapazität $CE_1$ plus Teilkapazität $C_{12}$ von Elektrode E1 zu Elektrode E2 plus Teilkapazität $C_{13}$ von Elektrode E1 zu Elektrode E2 proportional.

Die am Bandfilter BF 12 anstehende Spannung U12 ist der Teilkapazität $C_{21}$ zwischen den Elektroden E2 und E1 proportional und die am Bandfilter BF13 anstehende Spannung U13 ist der Teilkapazität $C_{31}$ zwischen den Elektroden E3 und E1 proportional.

Entsprechendes gilt für die Spannungen an den anderen Bandfiltern, wie aus Fig.2 ersichtlich. So ist z.B. am Bandfilter BF21 die Spannung U21 der Teilkapazität $C_{12}$ proportional. Auf diese Weise können aufgrund unter- schiedlicher Meßwege die Teilkapazität $C_{12}$ und die Teilkapazität $C_{21}$ ermittelt werden, die gleich groß sein müssen ($C_{21} = C_{12}$). Daraus ergibt sich

ein zusätzliches Kontrollkriterium für die Bewertung der Kapazitätsänderungen am kapazitiven Schutzzaun.

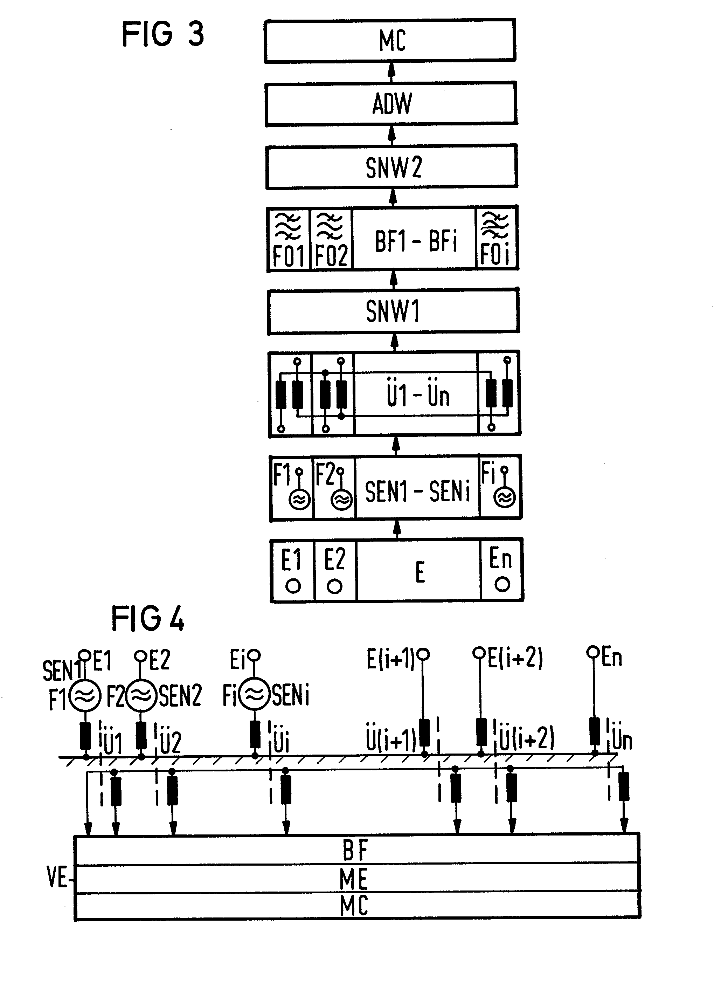

In Fig.3 ist im Blockschaltbild eine Meßanordnung dargestellt, die zwei Schaltnetzwerke benützt. Von unten nach oben betrachtet sind unten die Elektroden (E1 bis En) dargestellt, die mit den Sendern SEN1 bis SENi mit den Frequenzen F1 bis Fi verbunden sind. Die Übertrager Ü1 bis Ün sind primärseitig zwischen dem Sender und der Erde angeordnet. Sekundärseitig werden die Übertrager Ü1 bis Ün mit einem ersten Schaltnetzwerk SNW1 mit den Bandfiltern BF1 bis BFi, die für sämtliche Elektroden nur einmal vorhanden sind, verbunden. Mit einem zweiten Schaltnetzwerk SNW2 werden die Bandfilter BF1 bis BFi mit einem Analog/Digital-Wandler ADW verbunden, dem ein Mikrocomputer MC nachgeschaltet ist. Das Schaltnetzwerk SNW1 verbindet bei beispielsweise vier Elektroden (E1 bis E4) mit vier Sendern (SEN1 bis SEN4) in einem ersten Schaltschritt die vier Übertrager Ü1 bis Ü4 mit den vier Bandfiltern BF1 bis BF4, so daß Ü1 mit BF1, Ü2 mit BF2 usw. verbunden sind. In einem zweiten Schaltschritt ist Ü1 mit BF4, Ü2 mit BF1, Ü3 mit BF2 und Ü4 mit BF3 verbunden. Es werden bei vier Sendeelektroden in vier Schaltschritten jeder Übertrager mit jedem Bandfilter einmal verbunden.

Ein ähnliches Schaltnetzwerk SNW2 ist notwendig, wenn zwischen den Bandfiltern (BF1 bis BFi) und dem Mikrocomputer MC nur soviele Analog/Digital-Wandler vorgesehen sind, wie Sender angeschlossen sind. Auch hier reduziert sich im Multiplexbetrieb die Anzahl der Analog/Digital-Wandler um den Faktor n.

In Fig.4 sind die Elektroden E1 bis Ei als Sendeelektroden betrieben, d.h. sie sind jeweils mit einem Sender SEN1 bis SENi und über die Primärwicklung des jeweiligen Überragers Ü1 bis Üi mit Erde verbunden. Die restlichen Elektroden E (i + 1) bis En sind direkt über die Primärwicklung der Überrager Ü (i + 1) bis Ün mit Erde verbunden. Die Sekundärseiten aller Übertrager Ü1 bis Ün sind mit den Bandfiltern BF11 bis BFni oder bei Multiplexbetrieb über das Schaltnetzwerk SNW1 mit den Bandfiltern BF11 bis BFi verbunden. Die Ausgänge der Bandfilter BF führen zur Meßeinrichtung ME und zum Mikrocomputer MC. In Fig.4 sind die Bandfilter BF, die Meßeinrichtung ME und der Mikrocomputer MC als eine Verarbeitungseinheit VE dargestellt.

Patentansprüche

1. Meßanordnung für kapazitive Schutzzäune mit einer Mehrzahl (n) von Elektroden (E) zur Bestimmung der einzelnen Teilkapazitäten (CT) zwischen jeweils zwei Elektroden und der Eigenteilkapazität (CE) zwischen jeweils einer Elektrode und Erde, wobei aus den ermittelten Kapazitätswerten (CT, CE) in einer zentralen Auswerteeinrichtung Alarm- bzw. Störungskriterien abgeleitet und Alarm- bzw. Störungsmeldungen angezeigt werden,

dadurch gekennzeichnet, daß zumindest an einigen Elektroden (E1 bis Ei) jeweils ein Sender (SEN1 bis SENi) mit jeweils unterschiedlicher Frequenz (F1 bis Fi) angeschaltet ist,

daß jeder Elektrode (E1 bis En) ein Übertrager (Ü1 bis Ün) zugeordnet ist, dessen Primärwicklung zwischen dem Sender (SEN) und Erde liegt,

daß jedem Übertrager (Ü1 bis Ün) sekundärseitig jeweils der Anzahl (i) der Sender (SEN) entsprechend viele Bandfilter (BF1 bis BFi) mit einstellbaren Mittel-frequenzen (FO1 bis FOi) nachgeordnet sind,

daß sämtlichen Bandfiltern (BF11 bis BFni) eine Meßeinrichtung (ME) nachgeschaltet ist, mit der für sämtliche Mittenfrequenzen (FO1 bis FOi) an allen Bandfiltern (BF11 bis BFni) die jeweiligen Spannungen (U11 bis Uni) gemessen werden,

und daß mit einem den Bandfiltern nachgeschalteten Mikrocomputer (MC) aus den gemessenen, den Kapazitäten proportionalen Spannungen (U11 bis Uin) sämtliche Teil- und Eigenteilkapazitäten (CT, CE) ermittelt werden.

2. Meßanordnung nach Anspruch 1,
dadurch gekennzeichnet, daß die Meßspannung (z.B. U11) an dem Bandfilter (BF11), das dem Sender (SEN1) zugeordnet ist, dessen Sendefrequenz (F1) gleich der

Mittenfrequenz (FO) dieses Bandfilters (BF11) ist, proportional der Summe aus allen Teilkapazitäten (CT) der an diesem Sender (SEN1) angeschlossenen Elektrode (E1) zu den übrigen Elektroden (E2 bis En) und der Eigenteilkapazität (CE1) ist, und daß die Meßspannungen (U12 bis Uni) an den übrigen Bandfiltern (BF12 bis BFin) jeweils der Teilkapazität (CT) der dem Bandfilter zugeordneten Elektrode zur Elektrode mit demjenigen Sender, dessen Frequenz gleich der Mittenfrequenz des Bandfilters ist, proportional ist.

3. Meßanordnung nach Anspruch 1 oder 2, dadurch gekennzeichnet, daß die Meßeinrichtung (ME) Teil des Mikrocomputers (MC) ist, in dem auch Speicherplätze vorgesehen sind, in die bei gleichzeitiger Messung der einzelnen Spannungen (U11 bis Uni) die ermittelten Teilkapazitäten (CT) und Eigenteilkapazitäten (CE) einspeicherbar und für die Ableitung von Alarm- bzw. Störungskriterien auslesbar sind.

4. Meßanordnung nach Anspruch 1, dadurch gekennzeichnet, daß zur gleichzeitigen Messung aller Teilkapazitäten (CT) die Anzahl (i) der Sender (SEN) gleich der Anzahl (n) der Elektroden (E) ist.

5. Meßanordnung nach Anspruch 1, dadurch gekennzeichnet, daß die Anzahl (i) der Sender (SEN) kleiner ist als die Anzahl (n) der Elektroden (E1).

6. Meßanordnung nach Anspruch 1, dadurch gekennzeichnet, daß für alle Übertrager (Ü1 bis Ün) nur einmal der Anzahl (i) der Sender (SEN) entsprechend viele Bandfilter (BF1 bis BFi) vorgesehen sind, die über Schaltnetzwerke (SNW1, SNW2) anschaltbar sind.

7. Meßanordnung nach Anspruch 1,
dadurch gekennzeichnet, daß zur Erzeugung der unterschiedlichen Frequenzen (F1 bis Fi), deren Anzahl (i)
der Anzahl der an die Elektroden (E) angeschlossenen
Sender (SEN) entspricht, ein rechnergesteuerter Teiler
einem quarzstabilisierten Muttergenerator zugeordnet
ist.

8. Meßanordnung nach Anspruch 1,
dadurch gekennzeichnet, daß die Bandfilter (BF1 bis BFi)
von einer phasenabhängigen Gleichrichtungseinrichtung
gebildet sind.

9. Meßanordnung nach einem der vorhergehenden
Ansprüche,
dadurch gekennzeichnet, daß die Teilkapazität ($C_{13}$ = $C_{31}$
= CT) zwischen zwei bestimmten Elektroden (E1, E3) aus
zwei verschiedenen, der jeweiligen Elektrode (E1, E3)
zugeordneten Meßspannungen (U13, U31) ermittelbar und
daraus ein zusätzliches Kontrollkriterium ableitbar ist.

FIG 1

FIG 2

FIG 3

FIG 4